(19) Europäisches Patentamt

European Patent Office

Office européen des brevets

(11) **EP 0 716 505 A1**

(12) **EUROPEAN PATENT APPLICATION**

(43) Date of publication:
**12.06.1996 Bulletin 1996/24**

(51) Int Cl.$^6$: **H03F 1/32**

(21) Application number: **95308545.3**

(22) Date of filing: **28.11.1995**

(84) Designated Contracting States:
**AT DE ES FR GB IT**

(30) Priority: **09.12.1994 GB 9424877**

(71) Applicant: **PLESSEY SEMICONDUCTORS LIMITED**
**Swindon, Wiltshire SN2 2QW (GB)**

(72) Inventors:
• **Madni, Arshad**
**Swindon, Wilts SN3 2HA (GB)**
• **Watson, Ian Garth**
**Swindon, Wilts SN2 2RX (GB)**

(74) Representative: **Hoste, Colin Francis**
**The General Electric Company p.l.c.**
**GEC Patent Department**
**Waterhouse Lane**
**Chelmsford, Essex CM1 2QX (GB)**

(54) **Amplifier circuit arrangements**

(57) In an amplifier circuit arrangement in which series resistive feedback is utilised to minimise distortion, an amplifier is provided in an additional feedback path from the output of the arrangement to the series feedback path effectively to multiply the value of the resistive element by a factor so as to increase the amount of negative feedback applied without degrading the noise factor of the amplifier.

Fig 1

## Description

The present invention relates to amplifier circuit arrangements, and in particular to such arrangements utilising negative feedback.

Known radio frequency amplifier stages utilise shunt and series feedback to provide controlled input impedance and low distortion. However, to achieve really low distortion figures of, say, - 100dB requires a considerable amount of series feedback, effected either by increasing power levels or by increasing the value of the series feedback, or degeneration, resistor which in turn can degrade the noise figure of the stage.

According to one aspect of the present invention an amplifier circuit arrangement comprises a first amplifier having an input circuit connected to an input of the amplifier circuit arrangement, series negative feedback means connected in said input circuit, and an output circuit connected to an output of said amplifier circuit arrangement, and a second amplifier having an input connected to the output circuit of said first amplifier and an output connected to said series negative feedback means such as to provide further negative feedback to said input circuit of said first amplifier.

The first and second amplifiers may be differential amplifiers, and may each comprise an emitter-coupled or long-tail pair of bipolar or junction transistors. The transistors of said pair in said first amplifier may have respective series feedback resistors in their emitter paths.

According to another aspect of the present invention an amplifier circuit arrangement comprises a first pair of bipolar transistors having their emitter electrodes connected by way of respective first resistors to a first current source to form a first long-tail pair amplifier, a second pair of bipolar transistors having their emitter electrodes connected by way of respective second resistors to a second current source to form a second long-tail pair amplifier, means connecting respective base electrodes of said first pair of transistors to respective input terminals of said amplifier circuit arrangement, means connecting respective collector electrodes of said first pair of transistors to respective output terminals of said amplifier circuit arrangement and to respective base electrodes of said second pair of transistors, and means connecting respective collector electrodes of said second pair of transistors to respective emitter electrodes of said first pair of transistors.

The means connecting respective collector electrodes of said first pair of transistors to said respective output terminals may comprise respective further bipolar transistors connected in emitter-follower configuration.

Amplifier circuit arrangements in accordance with the present invention will now be described with reference to the accompanying drawings, of which:-

Figure 1 shows schematically an amplifier circuit arrangement in accordance with the invention,

Figure 2 shows diagrammatically an amplifier circuit arrangement shown in Figure 1, and

Figure 3 shows diagrammatically anotehr form of the amplifier circuit arrangement shown in Figure 1.

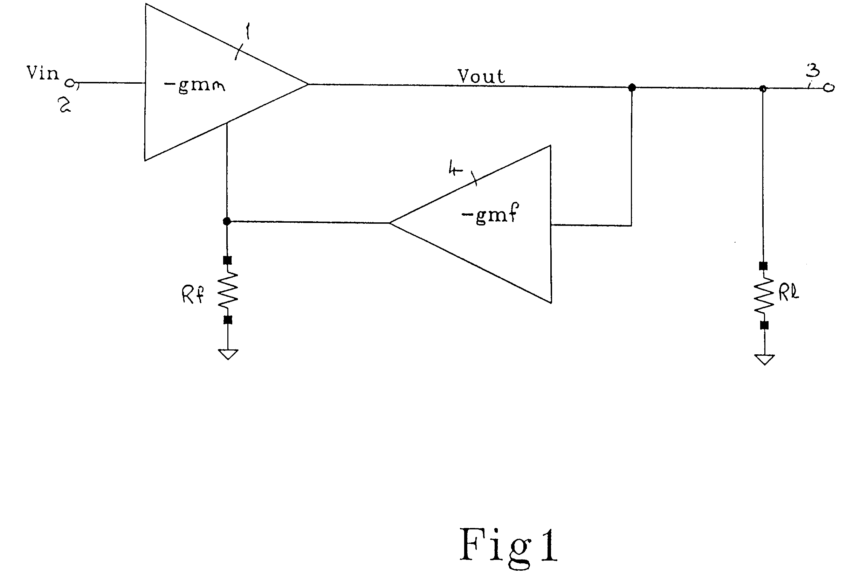

Referring first to Figure 1 the arrangement comprises a main amplifier 1 having a transconductance of -gmm which in response to an input signal voltage Vi at an input terminal 2 develops an output signal voltage Vo at an output terminal 3 across a load resistor Rl. The output signal voltage Vo is applied to the input of a feedback amplifier 4 having a transconductance of -gmf the output of which is applied across a feedback resistor Rf in such a sense as to aid the negative feedback provided by the resistor Rf.

In the absence of the amplifier 4, due to the feedback across the resistor Rf the voltage gain of the arrangement would be given by:-

$$\frac{Vo}{Vi} = \frac{gmm.Rl}{(1 + gmm.Rf)}$$

In the arrangement as shown in Figure 1, by summing the currents in the resistor Rf it can be shown that the voltage gain may be expressed as:-

$$\frac{Vo}{Vi} = \frac{gmm.Rl}{(1 + gmm.Req)}$$

-where

$$Req = Rf (1 + gmf. Rl)$$

The result is that the effective value of the series feedback resistor R is increased by the factor (1 + gmf. R1).

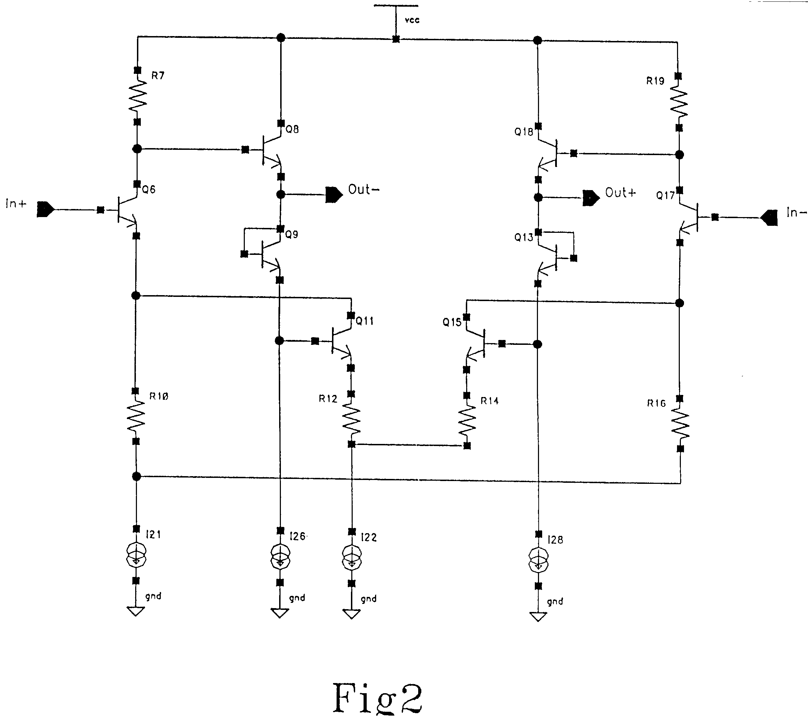

Referring now to Figure 2 a first differential input/differential output realisation of an amplifier in accordance with the present invention comprises a first long-tail pair amplifier formed by npn junction transistors Q6 and Q17, emitter resistors R10 and R16 and a current source I21. The differential output voltages from the collectors of the transistors Q6 and Q17, developed across respective load transistors R7 and R19, are applied by way of respective emitter follower transistors Q8 and Q18 to differential output terminals of the arrangement and by way of respective diode connected transistors Q9 and Q13 to respective inputs of a second long-tail pair amplifier comprising transistors Q11 and Q15, emitter resistors R12 and R14 and a current source I22. The collector electrodes of the transistors Q11 and Q15 are connected respectively to the emitter electrodes of the transistors Q6 and Q17.

The long-tail pair amplifier comprising transistors Q6 and Q17, together with the emitter followers Q8 and Q18, form the main transconductance amplifier 1 of Figure 1, while the long-tail pair amplifier comprising transistors Q11 and Q15 forms the feedback transconductance amplifier 4.

Respective voltage feedback resistors (not shown) may be connected between the emitter electrode of the transistor Q8 and the base electrode of the transistor Q6, and between the emitter electrode of the transistor Q18 and the base electrode of the transistor Q17, in order to set the input impedance of the amplifier arrangement to a required value.

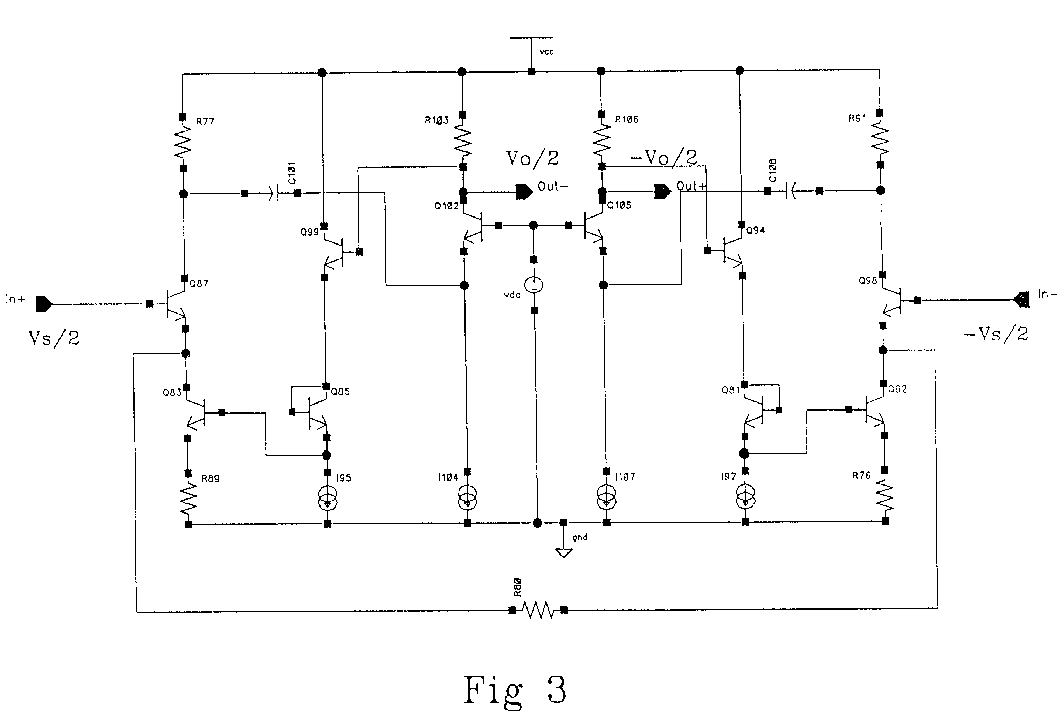

Referring now to Figure 3 a second differential input/differential output realisation comprises a first differential amplifier formed by transistors Q87 and Q98 having their emitter electrodes interconnected by way of a resistor R80. The emitter electrodes of these transistors are connected to ground by way of the output transistors Q83 and Q92 respectively which form part of the feedback amplifier.

The voltages developed across load resistors R77 and R91 are a.c. coupled to the inputs of common base stages comprising transistor Q102 and resistor R103 and transistor Q105 and resistor R106 respectively, the outputs of these common base stages being connected to respective differential outputs of the arrangement and, by way of emitter follower transitors Q99 and Q94 to the collector electrodes of diode-connected transistors Q85 and Q81 respectively the emitter electrodes of which are connected to the base electrodes of transistors Q83 and Q92 respectively. The a.c. coupled common base output stages provide gain to compensate for the lowered gm of the main amplifier while avoiding limitations on "headspace" imposed by restricted supply voltages on an all-npn circuit.

## Claims

1. An amplifier circuit arrangement comprising a first amplifier having an input circuit connected to an input of the amplifier circuit arrangement, series negative feedback means connected in said input circuit, and an output circuit connected to an output of said amplifier circuit arrangement, and a second amplifier having an input connected to the output circuit of said first amplifier and an output connected to said series negative feedback means such as to provide further negative feedback to said input circuit of said first amplifier.

2. An amplifier circuit arrangement in accordance with Claim 1 wherein said first and second amplifiers are differential amplifiers.

3. An amplifier circuit arrangement in accordance with Claim 2 wherein each of said amplifiers includes a long-tail pair amplifier comprising a respective pair of junction transistors having their emitter electrodes coupled in common to a respective current source.

4. An amplifier circuit arrangement in accordance with Claim 3 wherein the pair of transistors of said first amplifier have their emitter electrodes connected to the respective current source by way of respective series feedback resistors.

5. An amplifier circuit arrangement comprising a first pair of bipolar transistors having their emitter electrodes connected by way of respective first resistors to a first current source to form a first long-tail pair amplifier, a second pair of bipolar transistors having their emitter electrodes connected by way of respective second resistors to a second curent source to form a second long-tail pair amplifier, means connecting respective base electrodes of said first pair of transistors to respective input terminals of said amplifier circuit arrangement, means collecting respective connector electrodes of said first pair of transistors to respective output terminals of said amplifier circuit arrangement and to respective base electrodes of said second pair of transistors, and means connecting respective collector electrodes of said second pair of transistors to respective emitter electrodes of said first pair of transistors.

6. An amplifier circuit arrangement in accordance with Claim 5 wherein said means connecting respective collector electrodes of said first pair of transistors to said respective output terminals comprises respective further bipolar transistors connected in emitter-follower configuration.

7. An amplifier circuit arrangement in accordance with Claim 5 or Claim 6 wherein respective voltage feedback resistors are provided between respective output and input terminals of said amplifier circuit arrangement to determine the value of input impedance of said arrangement.

8. An amplifier circuit arrangement comprising a first pair of bipolar transistors having their emitter electrodes coupled to form a first differential pair amplifier, a second pair of bipolar transistors connected to form a second differential-pair amplifier, means connecting respective base electrodes of said first pair of transistors to respective input terminals of said amplifier circuit arrangement, means connecting respective collector electrodes of said first pair of transistors to input electrodes of said second pair of transistors, and means connecting collector electrodes of said second pair of transistors to respective emitter electrodes of said first pair of transistors.

9. An amplifier circuit arrangement in accordance with Claim 8 wherein respective collector electrodes of said second pair of transistors are connected to output terminals of said amplifier circuit arrangement, and said means connecting said respective collector electrodes of said second pair of transistors to respective emitter electrodes of said first pair of transistors comprises respective third bipolar transistors connected in emitter-follower configuration.

10. An amplifier circuit arrangement in accordance with Claim 8 or Claim 9 wherein the transistors of said second pair are connected in common base configuration.

11. An amplifier circuit arrangement in accordance with Claim 9 wherein the emitter electrodes of the transistors of said first pair are connected to respective current sources comprising respective fourth bipolar transistors, the respective emitter electrodes of said respective third transistors being connected to the respective base electrodes of said respective fourth transistors.

EP 0 716 505 A1

Vin

−gmm

1

Vout

3

4

−gmf

Rf

Rℓ

Fig 1

Fig2

Fig 3

EP 0 716 505 A1

**European Patent Office**

## EUROPEAN SEARCH REPORT

Application Number

EP 95 30 8545

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP-A-0 543 708 (THOMSON COMPOSANTS MILITAIRES ET SPATIAUX) <br> * column 3, line 26 - column 4, line 43; figures 2,3 * <br> --- | 1 | H03F1/32 |
| X | PATENT ABSTRACTS OF JAPAN <br> vol. 12 no. 94 (E-593) [2941] ,26 March 1988 <br> & JP-A-62 227204 (NEC CORP.) <br> * abstract * <br> --- | 1,2 | |
| A | US-A-3 688 209 (JAN TE WINKEL) <br> * column 4, line 22 - column 6, line 42; figures 2,4 * <br> --- | 2,3 | |
| A | PROCEEDINGS OF THE IEEE 1993 CUSTOM INTEGRATED CIRCUITS CONFERENCE, <br> 9 May 1993 SAN DIEGO CA, <br> pages 6.4.1.-6.4.7., XP 000409655 <br> Y.P. TSIVIDIS 'INTEGRATED CONTINUOUS-TME FILTER DESIGN' <br> * page 6.4.5; figure 10 * <br> ----- | 2,3 | TECHNICAL FIELDS SEARCHED (Int.Cl.6) <br><br> H03F |

The present search report has been drawn up for all claims

| Place of search | Date of completion of the search | Examiner |
|---|---|---|
| THE HAGUE | 19 March 1996 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)